## Europäisches Patentamt
## European Patent Office
## Office européen des brevets

(19)

(11) Veröffentlichungsnummer: **0 033 452**

**A2**

(12) **EUROPÄISCHE PATENTANMELDUNG**

(21) Anmeldenummer: **81100275.7**

(22) Anmeldetag: **15.01.81**

(51) Int. Cl.³: **G 11 C 7/00**
**G 11 C 11/24**

(30) Priorität: **21.01.80 DE 3002017**

(43) Veröffentlichungstag der Anmeldung:
**12.08.81 Patentblatt 81/32**

(84) Benannte Vertragsstaaten:
**FR GB**

(71) Anmelder: **SIEMENS AKTIENGESELLSCHAFT Berlin
und München**
**Postfach 22 02 61**
**D-8000 München 22(DE)**

(72) Erfinder: **Hoffmann, Kurt, Dr.-Ing.**
**Nelkenweg 20**
**D-8028 Taufkirchen(DE)**

(54) **Organisation einer monolithisch integrierten dynamischen Halbleiterspeichermatrix.**

(57) Die Erfindung befaßt sich mit der Aufgabe, einen MOSRAM-Speicher mit einer Matrix aus Eintransistor-Speicherzellen herzustellen, bei der den einzelnen Matrixspalten je ein unter anderem der Auffrischung der gespeicherten Informationen dienender Komparator (DLV) und eine Vergleichszelle an der anderen Seite des Komparators zugeordnet ist. Dabei soll die Ladungsspeicherkapazität der Vergleichszelle der Ladungsspeicherkapazität (C) der eigentlichen Speicherzellen (C, T) betragen. Andererseits ist für die Ladungsspeicherkapazität (C) der eigentlichen Speicherzellen (C, T) der kleinste und technologisch realisierbare Wert angestrebt. Um dies zu ermöglichen, wird gemäß der Erfindung anstelle einer einzigen Vergleichszelle (T*, C*) die Kombination zweier Vergleichszellen (Ts, Cs, ts, cs) angewendet, wobei die eine Vergleichszelle (ts, cs) an denselben Eingang des Komparators wie die Speicherzellen und die andere Vergleichszelle (Ts, Cs) an den anderen Eingang (Referenzeingang) des Komparators (DLV) angeschaltet ist. Dabei ist die Ladungsspeicherkapazität (cs) der am selben Komparatoreingang wie die Speicherzellen liegenden Vergleichszelle (ts, cs) gleich der Ladungsspeicherkapazität der eigentlichen Speicherzellen (Ts, Cs) und die Ladungsspeicherkapazität der am anderen Komparatoreingang liegenden Vergleichszelle (Ts, Cs) 1,5-mal so groß.

FIG 2

SIEMENS AKTIENGESELLSCHAFT       Unser Zeichen

Berlin und München               VPA 80 P 1 0 0 9 E

BEZEICHNUNG GEÄNDERT
siehe Titelseite

Monolithisch integrierter Halbleiterspeicher

Die Erfindung betrifft einen monolithisch integrierten Halbleiterspeicher mit einer Matrix aus zeilen- und spaltenweise angeordneten und einander gleichen Speicherzellen in Gestalt jeweils eines Feldeffekttransistors vom Anreicherungstyp mit einer zum Beispiel durch einen MOS-Kondensator gegebenen Speicherkapazität, bei dem entweder jeder Matrixspalte oder jeder Matrixzeile je ein Komparator und eine ebenfalls durch eine Speicherzelle der genannten Art gegebene Vergleichszelle zugeordnet ist.

Halbleiterspeicher dieser Art werden als dynamische Schreib-Lese-Speicher, also RAM-Speicher, betrieben und sind zum Beispiel in der Literaturstelle "Siemens Forsch.- und Entwickl.-Ber.", Bd. 4 (1975), Nr. 4, Seiten 207 bis 212 beschrieben.

Bei der üblichen Organisation solcher RAM-Speicher ist jeder Spalte des Matrixspeichers je ein als Differenzverstärker wirksamer Komparator zugeteilt, der sich in der Mitte der betreffenden Spalte befindet und durch eine bistabile Kippstufe gegeben ist. Die eine Hälfte der insgesamt pro Spalte vorgesehenen Eintransistor-Speicherzellen ist mit ihrem Drainanschluß an den einen Eingang des Differenzverstärkers und die übrigen Speicherzellen der betreffenden Matrixspalte in derselben Weise an den anderen Eingang des Differenzverstärkers geschaltet. Weiterhin sind jeder Spalte zwei Vergleichszellen

Stg 1 Dx / 18.01.1980

zugeordnet, die in gleicher Weise wie die eigentlichen Speicherzellen an je einen Eingang des Differenzverstärkers gelegt sind.

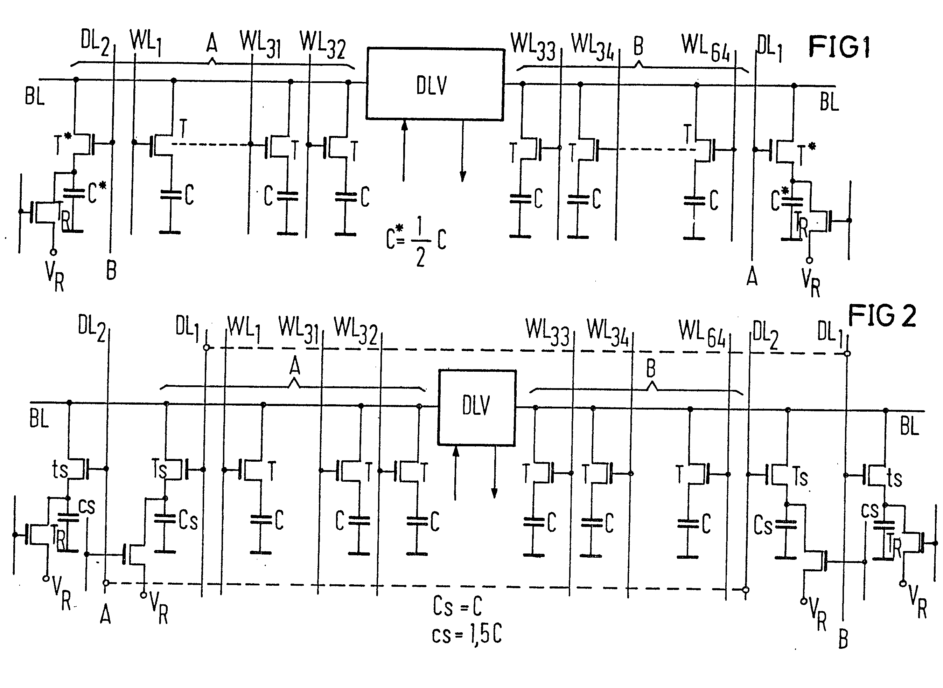

Im einzelnen hat man dann das aus Fig. 1 ersichtliche Schaltungsbild bei den einzelnen Spalten der Speichermatrix.

Verwendet man, wie üblich, für die den einzelnen Matrixzeilen zugeordneten und mit den Gateelektroden sämtlicher Speicherzellen der betreffenden Matrixzeile verbundenen Leitungen die Bezeichnung "Wortleitung" und für die den einzelnen Matrixspalten zugeordneten Leitungen die Bezeichnung "Bitleitung", so ist bei den üblichen Speichern dieser Art jede Bitleitung BL halbiert und die eine Hälfte an den einen Eingang des Differenz-Leseverstärkers und die andere Hälfte an den anderen Eingang dieses Verstärkers gelegt. Die pro Spalte vorgesehene Anzahl von Speicherzellen ist dementsprechend ebenfalls halbiert und je die halbe Anzahl der der betreffenden Spalte zugeordneten Speicherzellen an je eine Hälfte der betreffenden Bitleitung BL angeschlossen.

Jede der Speicherzellen besteht aus einem Feldeffekttransistor T vom MOS-Typ, der insbesondere unter den Gesichtspunkten der $Si^2$-MOS-Technik oder der Doppellagenn-Silicium Technologie hergestellt und aufgebaut ist und der mit seinem Drain an die ihm zugeordnete Hälfte der Bitleitung BL und mit seinem Sourceanschluß über die Speicherkapazität C an eine Referenzspannung, zum Beispiel an Masse, also im Betrieb an das gemeinsame Bezugspotential $V_{SS}$, gelegt ist. Die Kapazität C kann durch einen über die Gateelektrode des Transistors T hinausragenden Teil der Sourcezone des betreffenden Transistors T und einer zweiten über diesen Teil der Sourcezone isoliert angeordneten Elektrode oder durch den pn-Übergang zwischen Sourcezone und dem Kanalbereich des Transistors T gegeben sein. Die Gateelektroden jedes der Transistoren T liegen an je einer Wortleitung WL, wodurch die Verbindung zu den innerhalb der gleichen Matrixzeile wie der jeweils betrachtete Transistor T liegenden Speicherzellen hergestellt ist. Beispielsweise hat man innerhalb jeder Zeile und innerhalb jeder Spalte der Matrix 64 Speicherzellen T, C. Dann befinden sich innerhalb jeder Matrixspalte beiderseits des ihr jeweils zugeordneten Differenz-Leseverstärkers DLV jeweils 32 solcher Speicherzellen T, C, wobei die eine Hälfte durch je eine der Wortleitungen $WL_1$ bis $WL_{32}$ und die andere Hälfte durch je eine der Wortleitungen $WL_{33}$ bis $WL_{64}$ adressierbar ist.

Jeder der beiden Bitleitungshälften ist noch eine weitere Speicherzelle $T^*$, $C^*$ zugeordnet, die je eine Vergleichszelle darstellt. Der Transistor dieser Vergleichszellen ist mit $T^*$ bezeichnet und ist entsprechend den Transistoren T der eigentlichen Speicherzellen an die betreffende Hälfte der Bitleitung BL und damit an je einen der beiden Eingänge des Differenz-Leseverstärkers, also des Komparators DLV, an die ihm zugeordnete Ladekapazität $C^*$ und über sein Gate an eine zeilenparallel verlaufende, sogenannte Dummy-Leitung DL angeschlossen, wie dies auch aus der Literaturstelle "1977 IEEE International Solid-State Circuits Conference", Seite 12 und 13 entnehmbar ist.

Schließlich ist ein zwischen dem Transistor $T^*$ und der Speicherkapazität $C^*$ liegender Schaltungspunkt (also die Source des Transistors $T^*$) in jeder der beiden Vergleichszellen $T^*$, $C^*$ über einen der Entladung des Transistors $T^*$ dienenden weiteren Transistor $T_R$ an ein die Entladung ermöglichendes Betriebspotential $V_R$ anschaltbar.

Schon aus technologischen Gründen sind die beteiligten Transistoren T und T* bevorzugt vom selben Typ, also entweder n-Kanal-Transistoren oder p-Kanal-Transistoren, wobei man mit den erstgenannten Transistoren höhere Schaltgeschwindigkeiten erzielt. Dabei ist andererseits die Anwendung von Speicherzellen möglichst geringer Fläche erwünscht, um möglichst viel Speicherplätze auf dem Chip unterzubringen. Ein wesentlicher Faktor für den Platzbedarf der einzelnen Zelle ist durch die Speicherkapazität C gegeben, die nicht unbegrenzt reduziert werden kann, da sonst die in der einzelnen Zelle gespeicherte Ladung nicht mehr ausreichend ist, um die den Pegeln logisch "1" und logisch "0" entsprechenden Lesesignale zu liefern beziehungsweise um den Auffrischvorgang für die in den einzelnen Speicherzellen T, C gespeicherten binären Informationen auszulösen.

Andererseits ist bei den geringen Abmessungen der einzelnen Speicherzellen unausbleiblich, daß auch die Kapazität der Bitleitung BL mit ins Gewicht fällt. Aus diesem Grunde ist man gezwungen, auch dem Zustand logisch "0" eine von 0 Volt verschiedene Spannung der Bit-Leitung BL gegenüber Masse zuzuordnen. Sind beispielsweise die Speicherzellen in n-Kanaltechnik realisiert, so entsteht bei Anwendung der hierzu üblichen Dotierungs- und Abmessungsverhältnisse an dem aus monokristallinem Silicium bestehenden Speicherchip beim Auslesen des Zustands "1" eine Spannung von mindestens 6 Volt und beim Auslesen des Zustands logisch "0" eine Spannung von 5,6 Volt an der betreffenden Bitleitung BL beziehungsweise Bitleitungshälfte.

Der Komparator DLV hat nun die Aufgabe, zu unterscheiden, ob in einer durch Adressierung über die zugehörige Wortleitung an ihn angelegten Speicherzelle T, C entweder der Zustand "0" oder der Zustand "1" eingespeichert

0033452

ist, was sowohl für den Auslesevorgang bei der Auswertung als auch für den Auslesevorgang bei der Auffrischung erforderlich ist. Um den Vergleich zu ermöglichen, wird die Vergleichszelle $T^*$, $C^*$ an den anderen Eingang des Komparators DLV gelegt, der dann einen zwischen den beiden logischen Pegeln liegenden mittleren Spannungspegel erhalten muß.

Hierzu ist es erforderlich, daß die resultierende Speicherkapazität in der Vergleichszelle den halben Wert der Speicherkapazität der einzelnen eigentlichen Speicherzellen aufweist, da man dann auf einfache Weise die über Bitleitung BL gleichzeitig an die Drains der Speichertransistoren der betreffenden Matrixspalte und die Drains der mit den beiden Hälften der Bitleitung BL kombinierten Vergleichszellen $T^*$, $C^*$ gelegten Vergleichszellen in der für den Vergleich erforderlichen Weise kombinieren kann. Hierzu wird über die zugehörige Wortleitung WL die gewünschte Zelle der einen Bitleitungshälfte und über die zugehörige Dummy-Leitung DL die Vergleichszelle der jeweils anderen Bitleitungshälfte simultan adressiert und an je einen Eingang des insbesondere als Flip-Flop ausgebildeten Komparators gelegt. Ist dann die in der angewählten Speicherzelle vorhandene Ladung größer als die in der Vergleichszelle anwesende (und beständig aufgefrischte) Ladung, so gibt der Komparator das Signal logisch "1" und im anderen Fall das Signal logisch "0" ab, das dann in üblicher Weise ausgewertet wird.

Da man nun bestrebt ist, die Speicherkapazität in den einzelnen Speicherzellen soweit wie möglich zu reduzieren, bereitet es verständlicherweise Schwierigkeiten,

Vergleichszellen T$^*$, C$^*$ zu schaffen, für deren Kapazität die Beziehung

$$C^* = C/2$$

erfüllt ist. Ist nämlich $C_{min}$ die kleinste mit den zur Verfügung stehenden Mitteln realisierbare Kapazität, so kann sie aus ersichtlichen Gründen nur als Kapazität C für die Vergleichszellen, nicht aber für die Kapazität der Speicherzellen eingesetzt werden. Wünschenswert wäre aber, wenn man aus den oben genannten Gründen $C_{min}$ als Kapazität für die eigentlichen Speicherzellen einsetzen könnte.

Hier soll nun die Erfindung eine Abhilfe schaffen.

Erfindungsgemäß wird hierzu vorgesehen, daß jedem der Komparatoren jeweils zwei Vergleichszellen zugeordnet sind, von denen die erste die eineinhalbfache Speicherkapazität im Vergleich zu den eigentlichen Speicherzellen und die zweite denselben Wert der Speicherkapazität wie die eigentlichen Speicherzellen aufweist, und daß die Adressierung und Anschaltung der den einzelnen Komparatoren zugeordneten Speicherzellen und Vergleichszellen derart getroffen ist, daß simultan mit dem Anlegen einer Speicherzelle an den einen Eingang des Komparators ein Anschalten der dem Komparator zugeordneten zweiten Vergleichszelle an denselben Eingang und ein Anschalten der dem Komparator zugeordneten ersten Vergleichszelle an den anderen Eingang des Komparators gegeben ist.

Bei einer Ausgestaltung eines Speichers nach dem in Fig. 1 dargestellten Prinzip bedeutet dies, daß jede Bitleitungshälfte BL neben den ihr zugeteilten eigentlichen Speicherzellen jeweils eine erste Vergleichszelle $T_s$, $C_s$ und eine zweite Speicherzelle $t_s$, $c_s$ erhält, wobei

$$C_s = 1,5\ C \quad \text{und} \quad c_s = C$$

ist, wenn C die Ladungsspeicherkapazität der normalen, also der eigentlichen Speicherzelle ist. Der Entladungstransistor $T_R$ ist hier an den Sourceanschluß des Transistors $t_s$ der zweiten Vergleichszelle $t_s$, $c_s$ zu legen.

Die entsprechende Anordnung ist in Fig. 2 dargestellt. Entsprechend der Darstellung gemäß Fig. 1 sind auch hier die den einzelnen Matrixspalten zugeordneten Speicherzellen T, C in zwei gleichgroße Gruppen A und B unterteilt. Während bei einem Speicher gemäß Fig. 1 mit der Adressierung der einzelnen Speicherzellen der Gruppe A nur die Aktivierung der am anderen Eingang als die Zellen der Gruppe A des Komparators DLV angeschlossenen Vergleichszelle $T^*$, $C^*$ über die dieser zugeordnete Dummy-Leitung $DL_1$ und mit der Adressierung von Speicherzellen der Gruppe B die Aktivierung der am anderen Eingang als die Zellen der Gruppe B des Komparators DLV angeschlossenen Vergleichszelle über die dieser zugeordnete Dummy-Leitung $DL_2$ ausgelöst ist, hat man bei dem erfindungsgemäßen Speicher gemäß Fig. 2 zusätzlich noch die Aktivierung der am selben Eingang des Komparators DLV wie die adressierte Speicherzelle anzuschließenden zweiten Vergleichszelle $T_s$, $C_s$. Dies ist unter anderem durch die gestrichelten Linien in Fig. 2 kenntlich gemacht.

Hinsichtlich des Platzbedarfs eines solchen Speichers ist zu vermerken, daß pro Spalte der Speichermatrix zusätzlich zu den normalen Speicherzellen und den zwei Vergleichszellen noch zwei zusätzliche Vergleichszellen entsprechend den normalen Speicherzellen erforderlich sind und außerdem die beiden ersten Vergleichszellen die 1,5-fache Speicherkapazität als die normalen Speicherzellen verlangen. Anderseits gestattet es die Erfindung, die normalen Speicherzellen und außerdem die zweiten Vergleichszellen $t_s$, $c_s$ auf minimale Kapazität und damit auf minimalen Platzbedarf einzustellen, so daß im Falle $n \geq 4$ ($n$ = Anzahl der Speicherzellen pro Matrixspalte) der Vorteil der Erfindung hinsichtlich Platzbedarf klar gegeben ist.

Da die simultane Ansteuerung zweier Vergleichszellen anstelle von nur einer Vergleichszelle mit der Adressierung der einzelnen Speicherzellen der Matrixspalten auch schaltungstechnisch keine merkliche zusätzliche Belastung bedeutet, ist der durch die Erfindung erzielte Vorteil klar ersichtlich.

Zu bemerken ist noch, daß die einander entsprechenden Vergleichszellen der einzelnen Matrixspalten entsprechen den innerhalb der einzelnen Matrixzeilen angeordneten normalen Speicherzellen über die ihnen zugeordneten Dummy-Leitungen $DL_1$, $DL_1^*$, $DL_2$ und $DL_2^*$ zeilenweise zusammengefaßt werden können, so daß ihre Adressierung dann der Adressierung der einzelnen Matrixzeilen über die ihnen zugeordnete Wortleitung WL entspricht. Die simultane Adressierung der zu den zwei verschiedenen Hälften der Bitleitungen gehörenden ersten und zweiten Vergleichszellen läßt sich ohne Schwierigkeiten durch entsprechende Schaltung des Zeilendekoders des Speichers erreichen.

Zu bemerken ist schließlich, daß die Rollen von Zeilen und Spalten der Matrix vertauscht sein können.

2 Figuren

5 Patentansprüche

Patentansprüche

1. Monolithisch integrierter Halbleiterspeicher mit einer Matrix aus zeilen- und spaltenweise angeordneten und einander gleichen Speicherzellen in Gestalt jeweils eines Feldeffekttransistors vom Anreicherungstyp mit einer zum Beispiel durch einen MOS-Kondensator gegebenen Speicherkapazität, bei dem entweder jeder Matrixspalte oder jeder Matrixzeile je ein Komparator und eine ebenfalls durch eine Speicherzelle der genannten Art gegebene Vergleichszelle zugeordnet ist, d a d u r c h   g e - k e n n z e i c h n e t ,   daß jedem der Komparatoren jeweils zwei Vergleichszellen zugeordnet sind, von denen die erste die eineinhalbfache Speicherkapazität im Vergleich zu den eigentlichen Speicherzellen und die zweite denselben Wert der Speicherkapazität wie die eigentlichen Speicherzellen aufweist, und daß die Adressierung und Anschaltung der den einzelnen Komparatoren zugeordneten Speicherzellen und Vergleichszellen derart getroffen ist, daß simultan mit dem Anlegen einer Speicherzelle an den einen Eingang des Komparators ein Anschalten der dem Komparator zugeordneten zweiten Vergleichszelle an denselben Eingang und ein Anschalten der dem Komparator zugeordneten ersten Vergleichszelle an den anderen Eingang des Komparators gegeben ist.

2. Halbleiterspeicher nach Anspruch 1, d a d u r c h   g e k e n n z e i c h n e t ,   daß die Komparatoren als Differenzverstärker (DLV) ausgebildet sind.

3. Halbleiterspeicher nach Anspruch 2, d a d u r c h   g e k e n n z e i c h n e t ,   daß die Komparatoren (DLV) als Flip-Flopzellen ausgebildet sind.

0033452

4. Halbleiterspeicher nach den Ansprüchen 1 bis 3, d a d u r c h  g e k e n n z e i c h n e t ,  daß jeder Spalte der Matrix aus Speicherzellen (T, C) je ein Komparator (DLV) zugeordnet ist, daß ferner die den einzelnen Matrixspalten zugeordneten Speicherzellen (T, C) in zwei gleichgroße Gruppen (A, B) unterteilt sind, daß außerdem jede der beiden Gruppen (A, B) von Speicherzellen durch je eine Vergleichszelle ($T_s$, $C_s$) erster Art und durch je eine Vergleichszelle ($t_s$, $c_s$) zweiter Art ergänzt ist und daß schließlich jede der beiden Gruppen (A, B) von Speicherzellen samt der mit ihnen jeweils zusammengefaßten Vergleichszelle ($t_s$, $c_s$) zweiter Art und der jeweils mit der anderen Gruppe (B, A) von Speicherzellen zusammengefaßten Vergleichszelle ($T_s$, $C_s$) erster Art jeweils simultan adressierbar ist.

5. Halbleiterspeicher nach den Ansprüchen 1 bis 4, d a d u r c h  g e k e n n z e i c h n e t ,  daß die Transistoren (T, $T_s$, $t_s$) der Speicherzellen und der Vergleichszellen in n-Kanaltechnik ausgeführt sind.

FIG 1

FIG 2

1/1

0033452